# DEMANDE DE BREVET EUROPEEN

(11) **EP 0 955 673 A1**
(43) Date de publication de la demande: **10.11.1999**
(21) Numéro de dépôt: 99410038.6
(22) Date de dépôt: 26.04.1999
(51) Int. Cl.: H01L 21/8239, H01L 21/762

(54) **Procédé de fabrication de dispositifs EEPROM**

(30) Priorité: 28.04.1998 FR 9805628
(71) Demandeur: STMicroelectronics S.A., 94250 Gentilly (FR)
(72) Inventeur: Mirabel, Jean-Michel, 13480 Cabries (FR)
(74) Mandataire: de Beaumont, Michel

(57) **Abrégé**

L'invention concerne un procédé de fabrication dans un substrat (1) de type P comportant des zones actives séparées par des zones d'oxyde de champ (12), de régions d'arrêt de canal (18-1) fortement dopées sous des portions des zones d'isolement de champ, de zones plus faiblement dopées de type P (16) et N (14) destinées à former des caissons de transistors MOS, et de zones fortement dopées de type N destinées à former la première électrode (19) d'une capacité, comprenant les étapes consistant à :
effectuer une implantation, à haute énergie, de type N dans des zones de transistor MOS à canal P ;
effectuer une implantation, à haute énergie, de type P dans des zones de transistor MOS à canal N ;
effectuer une implantation, à haute énergie, de type P dans des zones d'arrêt de canal (68-1) et dans des zones de capacité (18-2) ; et
effectuer une implantation (19), à basse énergie, de type N, masquée par l'oxyde de champ.

## Description

La présente invention concerne de façon générale le domaine de fabrication de composants semiconducteurs. Plus particulièrement, la présente invention concerne la fabrication simultanée dans un substrat semiconducteur de capacités, de transistors basse tension et de transistors haute tension, par exemple, pour des dispositifs mémoire de type EEPROM.

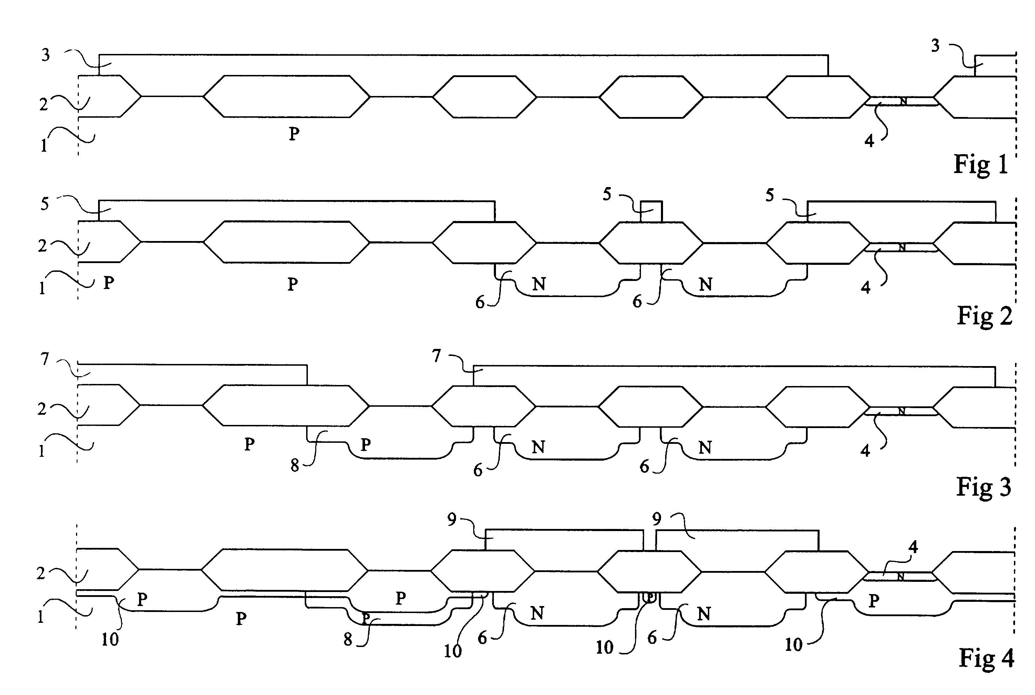

Les figures 1 à 4 illustrent de façon schématique et vue en coupe des étapes successives d'un procédé de fabrication de différents composants semiconducteurs sur un même substrat selon un procédé classique.

Comme l'illustre la figure 1, on considère un substrat 1 faiblement dopé d'un premier type de conductivité (ci-après le type P) dans lequel ont été définies des zones actives entre des zones d'oxyde de champ 2. On dépose et on grave un premier masque 3 de façon à découvrir seulement les zones dans lesquelles doivent être formées des capacités. Ensuite, à travers les ouvertures de ce premier masque 3, on implante à basse énergie un dopant de type N afin de créer une première électrode 4 d'une capacité.

Comme l'illustre la figure 2, après avoir enlevé le premier masque 3, on dépose et on ouvre un deuxième masque 5 de façon à découvrir seulement les zones dans lesquelles doivent être formés des transistors basse tension à canal P. Ensuite, on réalise à travers les ouvertures de ce deuxième masque 5 une implantation à haute énergie, rétrograde, de type N de façon à créer des caissons 6 de transistors basse tension à canal P. Cette implantation traverse l'oxyde épais et est éventuellement suivie d'une autre implantation de type N. Contrairement à ce qui est représenté, il n'est pas nécessairement prévu de région du masque 5 au-dessus des zones d'isolement entre transistors à canal P. Les caissons 6 de ces transistors à canal P peuvent donc être jointifs.

Comme l'illustre la figure 3, après avoir enlevé le deuxième masque 5, on dépose et on ouvre un troisième masque 7, de façon à découvrir seulement les zones dans lesquelles doivent être formés les transistors basse tension à canal N. Ensuite, on réalise à travers les ouvertures de ce troisième masque 7 une implantation à haute énergie, rétrograde, de type P de façon à créer des caissons 8 de transistors basse tension à canal N. Cette implantation traverse l'oxyde épais.

Aux étapes suivantes, illustrées en figure 4, on enlève le troisième masque 7, on dépose et on ouvre un quatrième masque 9, de façon à ne protéger que les zones dans lesquelles ont été formés les caissons 6 de type N des transistors basse tension à canal P. Dans le mode de réalisation représenté, les zones d'oxyde de champ 2 séparant deux transistors basse tension à canal P sont découvertes. Ensuite, on réalise à travers les ouvertures de ce quatrième masque 9 une implantation à haute énergie, rétrograde, de type P, de façon à former des régions 10 fortement dopées. Cette implantation traverse l'oxyde épais. Cette implantation 10 est formée sous les couches de capacité 4, en complément dans les zones 8 des transistors basse tension à canal N, ainsi que dans des zones de transistors haute tension à canal N. De plus, cette implantation 10 permet, si on le souhaite, d'éviter l'apparition d'un canal parasite entre les caissons de type N de deux transistors adjacents basse tension à canal P.

Ainsi, pour former les caissons de transistors basse tension à canal N et P, une zone d'électrode de capacité et des régions d'arrêt de canal, un procédé classique nécessite quatre étapes successives de masquage et d'implantation-diffusion.

Un objet de la présente invention est de prévoir un procédé de fabrication de dispositifs semiconducteurs comportant des zones dans lesquelles doivent être formées des capacités, des transistors basse tension à canal N et à canal P et des transistors à haute tension qui soient moins coûteux et moins long.

Pour atteindre cet objet, la présente invention prévoit un procédé de fabrication dans un substrat d'un premier type de conductivité comportant des zones actives séparées par des zones d'oxyde de champ, de régions d'arrêt de canal fortement dopées sous des portions des zones d'isolement de champ, de zones plus faiblement dopées d'un premier et d'un second type de conductivité destinées à former des caissons de transistors MOS, et de zones fortement dopées du second type de conductivité destinées à former la première électrode d'une capacité. Ce procédé comprend les étapes consistant à effectuer à travers les ouvertures d'un premier masque une première implantation, à haute énergie et rétrograde, du second type de conductivité dans des zones de transistor MOS d'un premier type de conductivité ; effectuer à travers les ouvertures d'un deuxième masque une deuxième implantation, à haute énergie et rétrograde, du premier type de conductivité dans des zones de transistor MOS d'un deuxième type de conductivité ; effectuer à travers les ouvertures d'un troisième masque une troisième implantation, à haute énergie et rétrograde, du premier type de conductivité dans des zones d'arrêt de canal et dans des zones de capacité ; et effectuer à travers les ouvertures du troisième masque une quatrième implantation, à basse énergie, du second type de conductivité, cette quatrième implantation étant masquée par l'oxyde de champ.

Selon un mode de réalisation de la présente invention, la troisième implantation est effectuée à une énergie de 240 keV.

Selon un mode de réalisation de la présente invention, la quatrième implantation est effectuée à une énergie de 80 keV.

Ces objets, caractéristiques et avantages, ainsi que d'autres de la présente invention seront exposés en détail dans la description suivante d'un mode de réalisation particulier faite à titre non-limitatif en relation avec les figures jointes parmi lesquelles :
les figures 1 à 4 illustrent des étapes d'un procédé classique ; et
les figures 5 à 7 illustrent des étapes d'un procédé selon la présente invention.

Par souci de clarté, et comme cela est habituel dans la représentation des circuits intégrés, les différentes figures ne sont pas à l'échelle. De plus, de mêmes éléments sont désignés par de mêmes références.

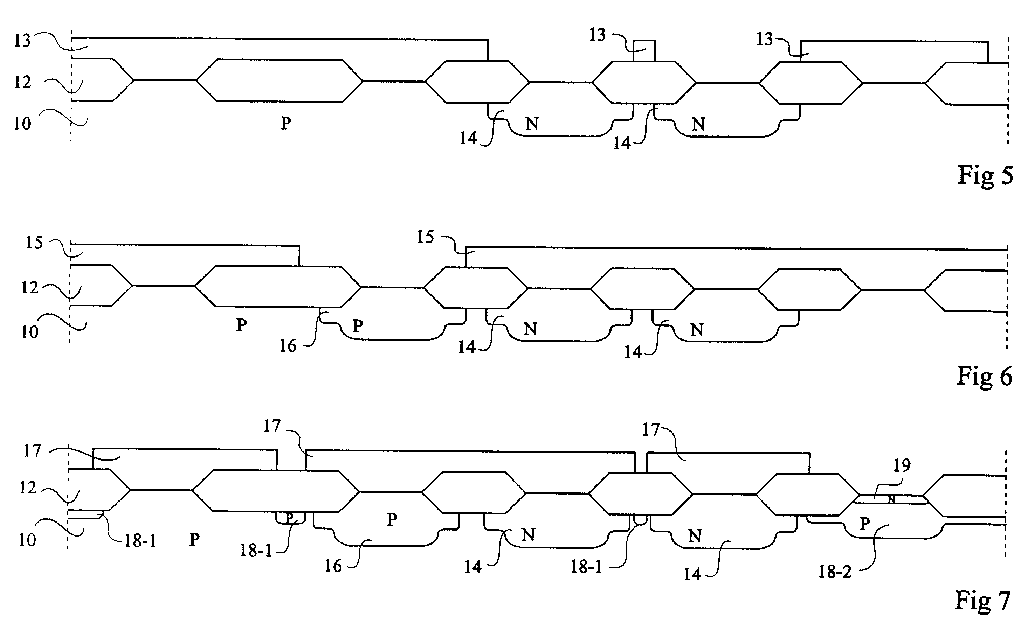

Les figures 5 à 7 représentent des vues en coupe schématiques illustrant des étapes successives d'un mode de réalisation d'un procédé selon l'invention de fabrication dans un même substrat d'une première électrode d'une capacité, de caissons de transistors basse tension et de régions d'arrêt de canal.

Comme l'illustre la figure 5, on part d'un substrat semiconducteur 10 de type P dans lequel ont été définies des zones actives entre des zones d'oxyde de champ 12. On dépose et on grave un premier masque 13 de façon à découvrir seulement les zones actives dans lesquelles doivent être formés des transistors basse tension à canal P. Ensuite, on réalise à travers les ouvertures de ce premier masque une implantation à très haute énergie, par exemple de l'ordre de 1 MeV, rétrograde, de type N de façon à créer des caissons 14 de transistors basse tension à canal P. Cette implantation traverse l'oxyde épais. Le masque 13 est identique au masque 5 de la figure 2 (le deuxième masque du procédé classique) et de la même façon la prévision de portions du masque 13 entre des caissons 14 est optionnelle.

Aux étapes suivantes, illustrées en figure 6, on retire le premier masque 13 et on le remplace par un deuxième masque 15. On ouvre le deuxième masque 15 de façon à découvrir seulement les zones dans lesquelles doivent être formés les transistors basse tension à canal N. Ensuite, on réalise à travers les ouvertures de ce deuxième masque 15 une implantation à haute énergie, par exemple de l'ordre de 600 keV, rétrograde, de type P, de façon à créer des caissons 16 de transistors basse tension à canal N. Cette implantation traverse l'oxyde épais. Le masque 15 est identique au masque 7 de la figure 2 (le troisième masque du procédé classique).

Aux étapes suivantes, illustrées en figure 7, on enlève le deuxième masque 15, on dépose un troisième masque 17 que l'on ouvre de façon à découvrir des parties des zones d'oxyde de champ 12 séparant deux transistors haute tension, ainsi que de façon à découvrir la zone dans laquelle doit être formée une électrode d'une capacité. On peut aussi, comme cela est représenté ouvrir le masque 17 dans des zones séparant les caissons 14 de deux transistors basse tension à canal P adjacents. Ensuite, on réalise à travers les ouvertures de ce troisième masque 17 une implantation à haute énergie, par exemple de l'ordre de 400 keV, rétrograde, de type P. Cette implantation traverse l'oxyde épais. Cette implantation forme des régions d'arrêt de canal 18-1 fortement dopées et une zone dopée 18-2 dans la zone dans laquelle doit être formée la capacité. Ensuite, on réalise à travers le même troisième masque 17 une implantation à basse énergie, par exemple de l'ordre de 80 keV, de type N. Cette implantation étant effectuée à faible énergie, le dopant ne traverse pas les parties des zones d'oxyde de champ 12 découvertes par le troisième masque 17, et donc ne modifie pas le dopage des zones d'arrêt de canal fortement dopées 18-1 sous-jacentes.

Ainsi, pour former les caissons de transistors basse tension à canal N et P, une zone d'électrode de capacité et des régions d'arrêt de canal, le procédé selon l'invention ne nécessite plus que trois étapes successives de masquage et d'implantation-diffusion.

Le procédé selon l'invention présente donc l'avantage d'économiser une des séquences d'étapes consistant à déposer puis enlever un masque (le masque 3 de la figure 1) destiné à permettre l'implantation de la zone d'électrode de capacité.

La structure selon l'invention présente l'avantage que les régions d'arrêt de canal 18-1 ne sont plus localisées dans les zones des transistors haute et basse tension qu'entre deux transistors adjacents, sous les zones d'oxyde de champ 12. Cela diminue les risques de modification des profils de dopage dans les caissons de ces transistors.

De plus, dans la zone active située à gauche de la figure, dans laquelle on veut réaliser un transistor MOS haute tension à canal N, il n'est pas prévu selon la présente invention de former l'implantation 10 décrite en relation avec la figure 4. Ceci permet d'améliorer encore la tenue en tension du transistor haute tension.

Bien entendu, la présente invention est susceptible de diverses variantes et modifications qui apparaîtront à l'homme de l'art. En particulier, bien que la présente invention ait été décrite dans le cas d'un mode de réalisation particulier (électrodes de type N et zones d'arrêt de canal de type P⁺ dans un substrat de type P), elle s'applique également à la formation de zones d'arrêt de canal de type N⁺ et d'électrodes de capacité de type P dans un substrat de type N.
NOTA :

A titre d'exemple, dans un mode de réalisation particulier de la présente invention, les implantations successives peuvent être faites de la façon suivante :
- implantation des caissons N à travers le masque 13 : phosphore, 10¹³ at./cm², 1,2 MeV
- implantation des caissons N à travers le masque 15 : bore, 10¹³ at./cm², 700 keV
- implantation de type P à travers le masque 17 : bore, 3,5 x 10¹² at./cm², 240 keV
- implantation de type N (19) à travers le masque 17 : phosphore 10¹⁴ at./cm², 80 keV

## Revendications

1. Procédé de fabrication dans un substrat (1) d'un premier type de conductivité comportant des zones actives séparées par des zones d'oxyde de champ (12), de régions d'arrêt de canal (18-1) fortement dopées sous des portions des zones d'isolement de champ, de zones plus faiblement dopées d'un premier (16) et d'un second (14) type de conductivité destinées à former des caissons de transistors MOS, et de zones fortement dopées du second type de conductivité destinées à former la première électrode (19) d'une capacité, caractérisé en ce qu'il comprend les étapes suivantes :
effectuer à travers les ouvertures d'un premier masque (13) une première implantation, à haute énergie et rétrograde, du second type de conductivité dans des zones de transistor MOS d'un premier type de conductivité ;
effectuer à travers les ouvertures d'un deuxième masque (15) une deuxième implantation, à haute énergie et rétrograde, du premier type de conductivité dans des zones de transistor MOS d'un deuxième type de conductivité ;
effectuer à travers les ouvertures d'un troisième masque (17) une troisième implantation, à haute énergie et rétrograde, du premier type de conductivité dans des zones d'arrêt de canal (18-1) et dans des zones de capacité (18-2) ; et
effectuer à travers les ouvertures du troisième masque une quatrième implantation (19), à basse énergie, du second type de conductivité, cette quatrième implantation étant masquée par l'oxyde de champ.

2. Procédé selon la revendication 1, caractérisé en ce que la troisième implantation est effectuée à une énergie de 240 keV.

3. Procédé selon la revendication 1 ou 2, caractérisé en ce que la quatrième implantation est effectuée à une énergie de 80 keV.
